# EUROPEAN PATENT SPECIFICATION

(11) **EP 2 151 852 B1**
(45) Date of publication and mention of the grant of the patent: **15.01.2020**
(21) Application number: 08290759.3
(22) Date of filing: 06.08.2008
(51) Int. Cl.: H01L 21/20, H01L 33/00, H01L 31/18, H01L 21/58, H01L 21/762

(54) **Relaxation and transfer of strained layers**
Relaxation und Übertragung von Spannungsschichten
Relâchement et transfert de couches tendues

(43) Date of publication of application: 10.02.2010
(73) Proprietor: Soitec, 38190 Bernin (FR)
(72) Inventor: Faure, Bruce, 38000 Grenoble (FR); Letertre, Fabrice, 38240 Meylan (FR); Guenard, Pascal, 38190 Froges (FR); Krames, Mike, 38190 Bernin (FR); McLaurin, Nelson, 38190 Bernin (FR); Gardner, Nate, 38190 Bernin (FR)
(74) Representative: Grünecker Patent- und Rechtsanwälte PartG mbB

(56) References cited:
- FR-A- 2 895 562
- US-A- 5 391 257
- US-A1- 2007 069 225
- US-A1- 2007 228 472
- US-B1- 6 214 733
- KOSTRZEWA M ET AL: "Feasibility of III-V on-silicon strain relaxed substrates" JOURNAL OF CRYSTAL GROWTH, ELSEVIER, AMSTERDAM, NL, vol. 275, no. 1-2, 15 February 2005 (2005-02-15), pages 157-166, XP025371737 ISSN: 0022-0248 [retrieved on 2005-02-15]
- YIN H ET AL: "Strain relaxation of SiGe islands on compliant oxide", JOURNAL OF APPLIED PHYSICS, AMERICAN INSTITUTE OF PHYSICS, US, vol. 91, no. 12, 15 June 2002 (2002-06-15) , pages 9716-9722, XP012055487, ISSN: 0021-8979, DOI: 10.1063/1.1479757
- HOBART K D ET AL: "Compliant substrates: a comparative study of the relaxation mechanisms of strained films bonded to high and low viscosity oxides", JOURNAL OF ELECTRONIC MATERIALS, WARRENDALE, PA, US, vol. 29, no. 7, 1 July 2000 (2000-07-01), pages 897-900, XP002565241, ISSN: 0361-5235, DOI: 10.1007/S11664-000-0177-2

## Description

### Field of Invention

The present invention relates to the field of compliant substrates employed in the manufacture of semiconductor devices and, in particular, to the relaxation of strained heteroepitaxial islands by means of compliant substrates and the transfer of the at least partially relaxed strained islands to some support substrate that can suitably be used for further semiconductor manufacture processes.

### Background of the Invention

When native bulk substrates are not available or are too expensive, useful materials are often formed by heteroepitaxy on seed substrates that have unsuitable atomic lattice spacing and different coefficient of thermal expansion. That results in detrimental effects on material quality of layers grown on them. They have high dislocation density, some cracks and compressively or tensively strains that leads to reduce the efficiency of devices, like optoelectronic or photovoltaic devices, subsequently manufactured on them.

Thus, in the art, compliant layers, e.g., low-viscosity layers, have been provided between the heteroepitaxial film and a final substrate in order to release the strains by heat treatment.

US 2007/0069225 A1 discloses a method of manufacturing a semiconductor structure including an n-type region, a p-type region, and a III-nitride light emitting layer disposed between the n-type region and the p-type region. The III-nitride light emitting layer has a lattice constant greater than 3.19 Å. Such a semiconductor structure may be grown on a substrate including a host and a seed layer bonded to the host. In some embodiments, a bonding layer bonds the host to the seed layer. The seed layer may be thinner than a critical thickness for relaxation of strain in the semiconductor structure, such that strain in the semiconductor structure is relieved by dislocations formed in the seed layer, or by gliding between the seed layer and the bonding layer an interface between the two layers. The host may be separated from the semiconductor structure and seed layer by etching away the bonding layer.

FR2895562 discloses bonding of a strained layer formed on an initial support onto a polymer layer, like PMDS, the polymer layer being chosen to be sufficiently flexible/mold at room temperature to cause the relaxation of the strained layer by ondulation when the initial support is removed. As the CTE of the polymer is chosen to be higher than the one of the strained layer, the further application of a thermal treatment allows the expansion of the polymer and the stretching of the strained layer such that ondulations are smoothed. Then, a support is bonded to the plane relaxed layer and is detached from the polymer layer. M. Kostrzewa et al., in a paper entitled "Feasibility of III-V on-silicon strain relaxed substrates", Journal of Crystal Growth, vol. 275, no. 1-2 pp. 157-166, 15 February 2005, teach patterning of strained material on a growth substrate in order to transfer the patterned strained material on a host substrate via a wax layer and to apply a thermal treatment to relax the island of strained material by melting of the wax at 100°C. A BPSG layer is employed to relax a continuous strained layer by application of thermal treatment and an epitaxial layer is grown on the relaxed continuous layer.

US5391257 discloses transferring a thin film of arbitrarily large area from an original substrate to an alternate substrate. An etch stop layer is provided below an epitaxial layer grown on a semiconductor substrate. In a single transfer process, the epitaxial layer is bonded to a rigid host substrate having desirable thermal, electromagnetic, and/or mechanical properties. The original growth substrate is then removed from the transferred epitaxial layer using the etch stop layer. In a double transfer process, the epitaxial layer is first bonded to a rigid and porous temporary substrate using a thermally or chemically releasable resin. The original growth substrate is removed using the etch stop layer so that the original substrate side of the epitaxial layer can be bonded to a rigid host substrate, as described above. The temporary substrate is then removed using the releasable resin to leave the transferred thin film attached to the host substrate.

US2007228472 teaches a method of manufacturing a semiconductor device including forming shallow trench isolation (STI) in a substrate and providing a first material and a second material on the substrate. The first material and the second material are mixed into the substrate by a thermal anneal process to form a first island and second island at an nFET region and a pFET region, respectively. A layer of different material is formed on the first island and the second island. The STI relaxes and facilitates the relaxation of the first island and the second island.

H. Yin et al., in a paper entitled "Strain relaxation of SiGe islands on compliant oxide", Journal of Applied Physics, vol. 91, no. 12, pp. 9716-9722, 15 June 2002, teach the relaxation of compressively strained epitaxial Si_{0.7}Ge_{0.3} films transferred to BPSG by a wafer bonding and etch back technique.

K.D. Hobart et al., in a paper entitled "Compliant Substrates: A Comparative Study pf the Relaxation Mechanisms of Strained Films Bonded to High and Low Viscosity Oxides", Journal of Electronic Materials, vol. 29, no.7, pp. 897-900, 2000, teach techniques of relaxation of Si_{0.7}Ge_{0.3} films bonded to high and low viscosity glass compliant layers wherein buckling could be avoided by patterning the strained films into small areas.

Presently used methods for the relaxation of strained heteroepitaxial films, however, often not show satisfying results with respect to the suppression of buckling, etc. Moreover, the transfer of heteroepitaxial films grown on a seed (growth) substrate to another substrate that is to be used for the further manufacture of a particular semiconductor raises the problem of maintaining the heteroepitaxial films intact, in general, and, in particular, removing the seed substrate without damaging the heteroepitaxial films.

Therefore, it is a problem underlying the present invention to provide a method for the formation of reliably relaxed and intact strained films (islands) on a target substrate that can suitably be used for the manufacture of a semiconductor device.

### Description of the Invention

The above-mentioned problem is solved by a method for the formation of at least partially relaxed strained material islands on a target substrate according to claim 1, the method comprising the subsequently performed steps of
transferring a strained material layer from a seed substrate to an intermediate substrate comprising depositing a compliant layer being a low-viscosity layer on the strained material layer and bonding the compliant layer to the intermediate substrate;
forming strained material islands from the strained material layer by patterning the strained material layer such that the strained material islands are separated by interspaces that extend down to the intermediate substrate such that substantially no material of the compliant layer remains on the bottom of the interspaces;
at least partially relaxing the strained material islands by a first heat treatment resulting in a plastical deformation and reflow of the compliant layer; and
transferring the at least partially relaxed strained material islands to a target substrate.

The material to relax may be a semi-conductor material such as III/V material, III/N, binary, ternary or quaternary, polar, non-polar or semi-polar. The formation of islands is performed by patterning of the strained material layer. In the following the term "strained material" refers to the strained material layer or the islands formed from the strained material layer.

According to this method, when the strained material is polar, as for the c-plane III/N material, and when the process is performed by growing the strained material on a seed substance following by a two-step transfer process from the seed substance to the intermediate substance, i.e. the substrate on that the islands are formed, and from the intermediate substance to the target substance, the polarity of the face of the relaxed strained material opposing the face of growth on the seed substance that is suitable for any subsequent epitaxial growth of layers can be maintained.

Furthermore, the strained material layer is grown on a seed substrate and transferred to the (intermediate) substrate on that the islands are formed. The step of transferring the strained material layer from the seed substrate to the intermediate substrate comprises depositing a low-viscosity layer, in particular, an oxide layer or a polymer layer being a compliant layer on the strained material layer and bonding the low-viscosity oxide layer to the intermediate substrate.

Similarly, the step of transferring the at least partially relaxed strained material layer to the target substrate may comprise depositing a high-viscosity layer, in particular, a second buried layer (e.g. an oxide layer), on the at least partially relaxed strained material, i.e. the at least partially relaxed islands, and bonding the high-viscosity layer to the target substrate.

Thus, the transfer to the intermediate substrate is readily achieved by a layer deposited both for bonding and at least partial relaxation (by means of the compliant material) of the strained material layer. The low-viscosity layer may be composed of different individual layers and comprises at least a compliant material layer (relaxing layer). By compliant material a material is particularly meant that shows some reflow (e.g. due to some glass transition) at a temperature above the glass transition temperature reached by heat treatment. The reflow (melting flow) results in an elastic strain relaxation of the strained material layer on that the low-viscosity layer, e.g., the above-mentioned buried (oxide) layer, is deposited. Suitable compliant materials include borophosphosilicate glass (BPSG) or an SiO₂ - compound comprising B (BSG) or P (PSG), for example (see also discussion below). For example, the glass transition temperature of a low-viscosity BPSG layer that contents 4.5 % of boron and 2 % of phosphorous is about 800°C. Most of low viscosity oxide materials have a glass transition temperature around 600-700°C whereas the glass transition temperature of the high-viscosity oxide material is above 1000°C and preferably above 1200°C.

Patterning of the strained material layer is carried out after transferring it from the seed substrate to the intermediate substrate thereby forming strained material islands separated by interspaces wherein the interspaces extend down to the intermediate substrate such that substantially no material of the low-viscosity layer remains on the bottom of the interspaces. It is particularly advantageous to etch the interspaces (trenches) down to the intermediate substrate or in the intermediate substrate such that material of the low-viscosity layer is only exposed at the sidewalls of the interspaces in order to improve the relaxation step and reduce diffusion of constituents of the low-viscosity layer (e.g. B and P atoms in the case of a borophosphosilicate glass).

Detachment of the seed substrate can be facilitated by the implantation of ions resulting in a weakened layer and subsequent heat treatment thereby intentionally causing cracking at the weakened layer. According to a further embodiment the seed substrate and the intermediate substrate and/or the intermediate substrate and the target substrate are of the same material, in particular, comprising silicon, sapphire, SiC, or Ge. It is particularly advantageous to choose the seed substrate and the intermediate substrate from the same material such that the coefficients of thermal expansion are the same and no tensions due to different thermal expansion are applied to the layer sandwiched by these substrates during a heat treatment (the above-mentioned third heat treatment) performed for the detachment of the seed substrate.

In regard of the detachment process(es), the low-viscosity layer and/or the high-viscosity layer (the first buried layer and/or the second buried layer) may comprise an absorption layer suitable for absorbing electromagnetic radiation and thereby facilitating detachment.

The strained material layer used in the above embodiments may comprise or consist of InGaN and the first buried layer may comprise or consist of borophosphosilicate glass (BPSG) or an SiO₂ - compound comprising boron or phosphorous.

Indium gallium nitride material is particularly useful for the manufacture of LEDs and the manufacture of solar cells, since it allows for absorption in a broad wavelength range (in particular, in the green, blue and ultraviolet range) of solar light. Whereas it is known in the art that relaxation of strained materials as heteroepitaxially grown Si_{0.7}Ge_{0.3} can be facilitated by patterning the strained layer and relaxing it by means of a reflow of a borophosphosilicate glass layer deposited on a support substrate and underlying the strained material islands (see, e.g., Hobart, K.D. et al., "Compliant Substrates: A Comparative Study of the Relaxation Mechanisms of Strained Films Bonded to High and Low Viscosity Oxides", Journal of Electronic Materials, Volume 29, No. 7, 2000, pages 897 - 900), the invention purposes patterning of a strained InGaN - layer, the relaxation of the patterned strained InGaN - layer and the transfer of the formed islands onto a target substrate.

Borophosphosilicate glass exhibits the desired reflow characteristics at temperatures exceeding about 800 °C or 850 °C (depending on the actual composition of the glass) thereby allowing for relaxation of the strained material layer such as InGaN material. Depending on the trench width, the strained material islands may form a sensibly continuous layer after relaxation of material. Adherence of the deposited buried layer comprising borophosphosilicate glass might advantageously be improved by depositing an SiO₂ layer on the Ga face of a strained InGaN layer (or different strained material layer) before the BPSG deposition.

As already mentioned above several types of semiconductor devices may be manufactures by using the at least partially relaxed strained material layer. Thus, herein is provided a method for the manufacture of a semiconductor device, comprising the formation of at least partially relaxed strained material on a target substrate according to one of the preceding claims, and further comprising epitaxially or homoepitaxially growing a material layer on the formed at least partially relaxed strained material islands. The growth technique may include the epitaxial lateral overgrowth that allows to reach a continuous material layer growth from material islands.

Additional features and advantages of the present invention will be described with reference to the drawings. In the description, reference is made to the accompanying figures that do not exactly show embodiments of the claimed invention. Rather, they differ from them in one or another detail but are helpful for understanding the same.
Figure 1 illustrates a method comprising the steps of the formation of a partially relaxed strain layer above a first substrate and the transfer of this layer to a second substrate.
Figure 2 illustrates steps of the formation of a structure comprising an intermediate substrate to that a strained material layer is transferred.
Figure 3 illustrates the formation of structure A shown in Figure 1 comprising patterning of a strained material layer on a buried layer bonded to a substrate.

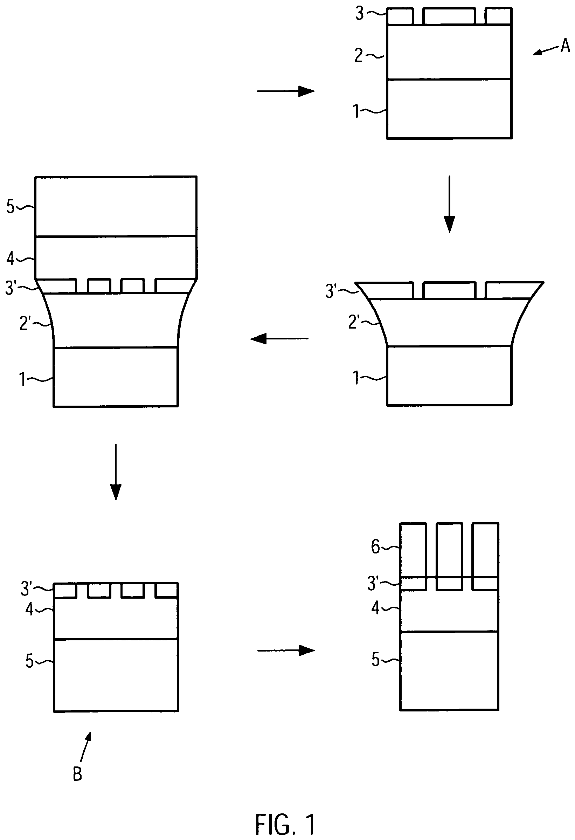

In the following, examples for the formation of relaxed islands of a strained material layer and the transfer of these islands are explained with reference to the accompanying Figures. According to Figure 1 some support substrate 1 is provided. The support substrate 1 might be made of a semiconductor material comprising Si, SiC, Ge, etc. or it might be sapphire support. Atop of the support substrate 1 a buried layer 2 is formed. The buried layer may be composed of different individual layers and comprises at least compliant layer (relaxing layer). The compliant layer includes without limitation borophosphosilicate glass (BPSG) or an SiO2 - compound comprising B (BSG) or P (BPG). The reflow rate can readily be adjusted by the B or P content.

In any case, the compliant layer comprises a material that can be plastically deformed and reflow when subjected to thermal treatment (as, e.g., an annealing process). The reflow leads to complete or partial relaxation of the strained material islands 3 that are bonded by the buried layer 2 to the support substrate 1. The strained material islands 3 are formed by patterning of a strained layer formed atop of the buried layer 2 comprising the compliant material layer. The strained material islands can, in particular, comprise or consist of InGaN. The shapes of the strained material islands 3 are arbitrary, in principle, and might be chosen to be circular or rectangular for ease of manufacture. Depending on the size of the surface of islands to relax, at least a hole may be performed in the islands to improve material relaxation without buckling. The hole may be of any shape such as circular, square or star shape and may be repeated in the same strained island. Moreover, the spaces (trenches) between the strained material islands 3 might be filled with material of the buried layer 2. Details of the manufacture of the structure A comprising the support substrate 1, the buried layer 2 and the strained material islands 3 are described below.

When the structure A is subject to thermal treatment the compliant layer of the buried layer 2 is plastically deformed and exhibits reflow and a plastically deformed buried layer 2' is obtained. The lateral deformation results in at least partially and elastically relaxed islands 3' thereby preventing buckling.. Indeed, surface roughness that might be affected by buckling effect is usually needed to be low for further applications. For an epitaxial growth for LED, the surface roughness after relaxation is preferably limited to 20 nm RMS measured by AFM.

Next, a second buried layer 4 is formed on top and between the at least partially relaxed islands 3'. The second buried layer 4 is used for bonding the at least partially relaxed islands 3' to a second support substrate 5. The second buried layer 4 preferably does not include contaminating elements that readily diffuse out of the layer 4 under thermal treatment that might be performed during subsequent processing steps, in particular, annealing for initiating detachment. The second buried layer 4 shall particularly be devoid of boron or any contaminating elements that could deteriorate the quality of LED elements formed on the at least partially relaxed islands 3', for example, when diffused in some heat treatment environment. The second buried layer 4 may, however, also comprise some compliant material allowing for further relaxation of the at least partially relaxed islands 3' after transfer to the second support substrate 5.

Both the buried layer 2 and the second buried layer 4 may comprise an absorbing layer for absorbing electromagnetic radiation at wavelengths for which the respective support substance is transmissive in order to enable detachment from the at least partially relaxed islands 3' and thereby removal of the support substance 1 or 5, respectively. Such an absorbing layer is preferably provided at the interface of the respective buried layer and the respective substrate and it may be formed of SixNy : H, for example.

Substrate 1 together with the buried layer 2 is subsequently detached and structure B is achieved comprising the second substrate 5, the second buried layer 4 and the at least partially relaxed islands 3'. The at least partially relaxed islands 3' can subsequently be used for the epitaxial growth of a structured material layer 6 and, in particular, for epitaxial or homoepitaxial growth of a crystalline layer, that is to be employed in the manufacture of a particular semiconductor device useful in electronic, photovoltaic or opto-electronic applications such as LEDs or lasers.

When a double-transfer of the patterned (partially relaxed) strained layer, i.e. the islands 3 and 3', respectively, is performed first to the first support substrate 1 and then to the second support substrate 5, the polar structure of the strained material (if a polar material is provided) as grown on a seed substrate (see below) is maintained in structure B. It is advantageous in particular for polar III/N materials to provide exposed the face of the polarity of the III element(s) for an easy epitaxial growth on the relaxed islands. This face is also the face that is generally provided after epitaxy on a seed substrate. It should be noted that whereas according to the present example the (partial) relaxation of the strained material islands 3 is performed by heat treatment of structure A and before transfer to the second support substrate 5, in principle, the at least partial relaxation of the strained material islands 3 may alternatively or additionally achieved by a heat treatment of structure B, i.e., after transfer to the second support substrate 5. However, herein the focus is laid on the transfer of the already relaxed strained material islands 3'. Transfer from the first support substrate 1 to the second support substrate 5 can be performed, e.g., by bond and grind/etch back, bond and electromagnetic absorption, Smart Cut® or any other layer transfer mechanism known in the art.

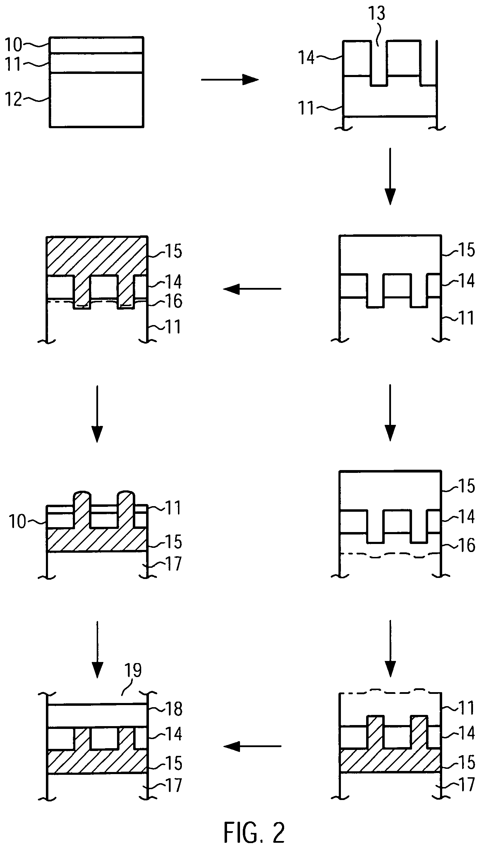

Next, the formation of a structure similar to structure A shown in Figure 1 is explained in more detail with reference to Figure 2. A strained material layer 10, e.g., of InGaN, is heteroepitaxially grown on a seed layer 11, e.g., of GaN, formed atop of a sapphire or SiC or silicon substrate 12 functioning as a seed substrate. The strained material may also be formed by epitaxy on a seed substrate that is a bulk substrate or that includes a seed layer bonded to a support substrate. The substrate is advantageously of the same material as the first support substrate 1 of Figure 1 to allow a matching of the coefficients of thermal expansion of these substrates when they are bonded and subject to heat treatment for subsequent detachment. The thickness of the strained material layer 10 may be some 100 nm, for example. The formation and patterning of heteroepitaxial films, in general, is well-known in the art (Hobart, K.D. et al., "Compliant Substrates: A Comparative Study of the Relaxation Mechanisms of Strained Films Bonded to High and Low Viscosity Oxides", Journal of Electronic Materials, Volume 29, No. 7, 2000, pages 897 - 900) and the particular method used for such a formation is not at all crucial in the present invention.

According to the example shown in Figure 2, the strained material layer 10 is patterned by etching trenches 13 and thereby forming strained material islands 14. The trenches 13 can be etched down to the support substance 12 or the seed material 11 is maintained with some predetermined thickness. The trenches may, e.g., be spaced in intervals of 100 micrometers to 1 mm and may have widths of about 25 micrometers and depths of about 150 nanometers. Depending on the application widths and/or depths of the trenches may be in the range of some hundred nanometers.

A buried compliant layer 15 is deposited as known in the art in the trenches 13 and atop of the strained material islands 14. The thickness of the buried layer 15 can be chosen such that surface irregularities are reduced, e.g., a thickness of three times the depths of the trenches is chosen.

Ion species are implanted in order to form an ion implantation region 16 at the bottom of the trenches 13 filled with the buried material 15 and below the strained material islands 14. Ion implantation results in a weakened bonding of the buried layer 15 and the strained material islands 14 to the seed layer 11 and, thus, facilitates detachment from the seed layer 11 after bonding to a support substrate 17. Surface planarization may precede the step of ion implantation, if it is desired. Detachment from the seed layer 11 can also be achieved by grinding.

If ion implantation is controlled such that the implantation depth exceeds the depths of the trenches (see rhs of Figure 2), i.e. ion implantation completely in the seed material is performed, the implantation is more homogenous than in the case in that an implantation is formed in the buried material at the bottom of the trenches (Ihs of Figure 2). Due to the more homogenous implantation profile surface planarization prior to the further processing such as the bonding of the substrate 19 is less difficult.

It is noted that ion implantation may also be performed in the strained layer and patterning may be carried out in the strained layer on the seed substrate as after transfer on the intermediate substrate.

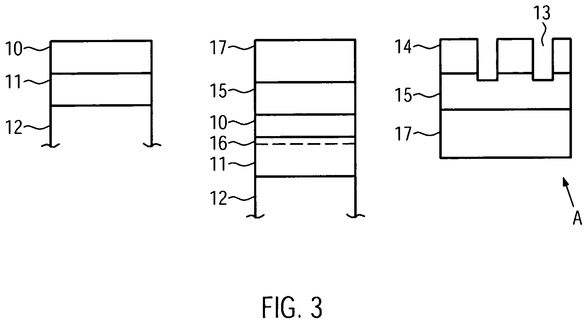

After transfer to the support substrate 17 heat treatment is performed in order to plastically deform the compliant material layer 15. This deformation results in at least partially relaxed strained material islands 14. In order to further reduce any buckling, residuals of the seed layer 11 may removed, e.g., by selective etching, after the heat treatment instead of performing it prior to the relaxation step. The relaxed structure is subsequently bonded via a second buried layer 18 to the second support substrate 19. Depending on the seed material 11, an heavy step of planarization may have been carried out when the implantation profile has been performed in the compliant layer and in the seed material to recover a sufficiently plane surface for the bonding. Whereas in the example shown in Figure 2 the strained material islands 14 are separated by the buried material 15, structure A shown in Figure 1 results, if the step of patterning the buried layer 15 is performed after the transfer of the strained material islands 14 to the first support substrate 17 (see Figure 3). According to the example shown in Figure 3, the strained material layer 10 grown on the seed layer 11 formed atop of the substrate 12 is bonded via the buried layer 15 to the support substrate 17 and ion implantation down to the strained material layer 10 or the seed layer 11 results in a weakened layer 16 with a rather homogeneous implantation profile (depth) thereby facilitating accurate detachment. Subsequently, trenches 13 are etched with depths of at least the thickness of the strained material layer 10. Alternatively, the trenches can be formed through the buried layer 15 down to the first support substrate 17. Next, a second buried layer (reference sign 18 of Figure 2) is formed for bonding to a second support substrate (reference sign 19 of Figure 2).

Alternatively, the step of patterning of the strained material layer 10 may be carried out even later in the sequence of processing steps. Patterning after the deposition of the second buried layer 18 results in bonding of individual strained material islands to the second support substrate.

Further, one might perform the patterning of the strained material layer 10 after partial etching of the seed layer 11 in order to adopt the thickness of the seed layer 11 to the one of the strained material layer 10. Heat treatment is then performed for the double layer stack consisting of the material of the seed layer 11 and the strained material layer 10 atop the compliant layer 15. Subsequent final removal of the material of the seed layer 11 may be accompanied by an additional annealing step to finish complete relaxation. Moreover, the seed layer 11 may be partially etched and the heat treatment may be carried out several times in sequence prior to the final removal of residuals of the seed layer material 11 that, in this case, functions as a stiffening means to further avoid buckling.

In a further alternative, heat treatment is performed for the entire structure comprising the first support substrate 17, the first buried layer 15, the strained material islands 14, the second buried (that may also be compliant layer) 18 and the second support substrate 19 (see Figure 2). The second substrate 19, in this case, is providing a stiffening effect in order to further avoid buckling of the strained material islands 14, which proves particularly advantageous for relatively large island sizes (e.g., 1 mm x 1 mm and more).

It should also be noted that if the seed layer 11 is GaN deposited on a sapphire substrate, detachment by laser lift off at the interface of the GaN layer and the sapphire substrate may also be performed during the process of transfer of the strained material islands. Moreover, if the seed layer 11 is a silicon wafer and detachment is achieved by the SMART CUT® process, the support substrate 17 advantageously is a silicon substrate to obtain similar coefficients of thermal expansion thermal treatment.

In the following, an example of the formation of an epitaxy layer of InGaN, useful for the manufacture of LEDs, lasers or solar cells, based on the relaxation and transfer of a strained layer is described.

First, a strained InGaN - layer comprising 5 - 7 % indium and of a thickness of about 100 nm is formed by heteroepitaxy on a GaN seed layer deposited on a sapphire seed substrate (corresponding to reference sign 12 of Figure 2). An oxide layer of SiO2 (or an undoped-silicon-glass) of a thickness of about 50 nm is deposited on the InGaN layer of gallium polarity to improve adherence with another substrate. A compliant layer of borophosphosilicate glass of a thickness of about 500 nm is subsequently formed on the oxide layer. The compliant layer comprises 4.5 % of boron and 2 % of phosphorous to achieve the desired relaxing effect. Hydrogen ion implantation is performed through the free surface of the compliant layer in order to form a weakened layer in the GaN seed layer and then the surface is polished, for example, by a CMP technique. Ion implantation is carried out with 4e17 atoms/cm2 and ion energies (about 120 keV) sufficient to pass through the compliant layer, the oxide layer and the InGaN layer.

An absorbing layer of SixNy:H and of a thickness of about 150 nm is deposited on another sapphire substrate (corresponding to reference sign 17 of Figure 2) and a bonding layer of borophosphosilicate glass is subsequently formed on the nitride layer and polished prior to bonding to the weakened structure including the InGaN strain layer. The resulting entire borophosphosilicate glass layer has a thickness of about 1 micrometer.

Next, fracture at the weakened layer and detachment of the initial sapphire seed layer together with the seed layer of GaN is achieved by thermal treatment at 450 °C for 10 hours. Note, that at this stage the temperature is kept below the melting (reflow) temperature of the borophosphosilicate glass layer. After the heat treatment the residual GaN seed material is dry etched to free the InGaN layer of N polarity. The InGaN layer is subsequently patterned to form trenches of 1 depths of 10 - 40 nm in the borophosphosilicate glass layer by a standard lithography process.

In a next step, annealing treatment is performed at 800 °C for 4 hours to cause reflow of the borophosphosilicate glass layer and the corresponding relaxation of the strained InGaN islands (of about 1002 to 3002 micrometers2) resulting from the patterning process. An SiN layer of a thickness of about 50 nm might be provided between the N face of the InGaN layer and the oxide layer of SiO2 (or an undoped-silicon-glass) to improve adherence between the InGaN layer and the oxide layer. In this case, the SiN layer functions as an absorbing layer that might be used for a detachment step.

An undoped-silicon-glass layer of a thickness of about 1 micrometer is deposited on a second sapphire substrate (corresponding to reference sign 19 of Figure 2). The combination of undoped-silicon-glass layers and the optional SiN layer form at least part of the buried layer 18 of Figure 2. Before bonding of the undoped-silicon-glass layers polishing of the bonding surfaces is performed. The entire thickness of the bonded undoped-silicon-glass layer may be about 1 micrometer (after polishing). Detachment of the substrate to which the InGaN strain layer formed by heteroepitaxy was transferred in the first transfer step (see reference sign 17 of Figure 2) is achieved by electromagnetic irradiation by means of an Ar/F laser providing light of 193 nm through the substrate that is transparent for that wavelength. Residuals of the SiN, undoped-silicon-glass and borophosphosilicate glass layers are subsequently removed by polishing and etching.

The resulting structure comprising completely relaxed InGaN islands of gallium polarity can be used for the homoepitaxial growth of material layers that are suitable for the manufacture of electronic, photovoltaic or opto-electronic devices. For instance, epitaxy of an InGaN material with the same or a comparable indium content as compared to the one of the relaxed InGaN islands can be performed.

## Claims

1. Method for the formation of at least partially relaxed strained material islands on a target substrate, comprising the subsequently performed steps of
transferring a strained material layer from a seed substrate to an intermediate substrate (1) comprising depositing a compliant layer (2) being a low-viscosity layer on the strained material layer and bonding the compliant layer (2) to the intermediate substrate (1);
forming strained material islands (3) from the strained material layer by patterning the strained material layer such that the strained material islands are separated by interspaces that extend down to the intermediate substrate (1) such that substantially no material of the compliant layer (2) remains on the bottom of the interspaces;
at least partially relaxing the strained material islands (3) by a first heat treatment resulting in a plastical deformation and reflow of the compliant layer (2); and
transferring the at least partially relaxed strained material islands (3) to a target substrate (5).

2. Method according to claim 1, wherein the step of transferring the at least partially relaxed strained material islands (3) to the target substrate (5) comprises depositing a another compliant layer (4) being a low-viscosity layer on the at least partially relaxed strained material islands (3) and bonding the other compliant layer (4) to the target substrate (5); and further comprising the step of relaxing the at least partially relaxed strained material islands (3) transferred to the target substrate (5) by a second heat treatment.

3. Method according to one of the claims 1 to 2, further comprising
growing the strained material layer on a seed substrate;
implanting ions in the seed substrate below the strained material to form a weakened layer; and
detaching the strained material from the seed substrate at the weakened layer by a another heat treatment.

4. Method according to one of the preceding claims, wherein the seed substrate and the intermediate substrate and/or the intermediate substrate and the target substrate are of the same material, in particular, comprising sapphire, silicon, SiC, or Ge.

5. Method according to one of the preceding claims, wherein the compliant layer (2) comprises an absorption layer suitable for absorbing electromagnetic radiation.

6. Method according to one of the preceding claims, wherein the strained material layer comprises or consists of InGaN and/or the compliant layer (2) comprises or consists of borophosphosilicate glass, BPSG, or an SiO₂ - compound comprising boron or phosphorous.

7. Method for the manufacture of a semiconductor device, comprising providing at least partially relaxed strained material (3) on a target substrate (5) according to one of the preceding claims, and further comprising epitaxially growing at least one material layer on the formed at least partially relaxed strained material, in particular, layers for LED or photovoltaic or laser device layers.

## Patentansprüche

1. Verfahren für die Ausbildung von zumindest teilweise relaxierten Inseln eines verspannten Materials auf einem Zielsubstrat, das die aufeinanderfolgend ausgeführten Schritte umfasst:
Transferieren einer Schicht eines verspannten Materials von einem Saatsubstrat zu einem Zwischensubstrat (1), mit Abscheiden einer verformbaren Schicht (2), die eine Schicht niedriger Viskosität ist, auf der Schicht des verspannten Materials und Bondieren der verformbaren Schicht (2) an das Zwischensubstrat (1);
Ausbilden von Inseln (3) eines verspannten Materials aus der Schicht des verspannten Materials durch Strukturieren der Schicht des verspannten Materials, sodass die Inseln des verspannten Materials durch Zwischenräume voneinander getrennt werden, die sich nach unten zu dem Zwischensubstrat (1) erstrecken, sodass im Wesentlichen kein Material der verformbaren Schicht (2) auf dem Boden der Zwischenräume verbleibt;
zumindest teilweises Relaxieren der Inseln (3) des verspannten Materials durch eine erste Wärmebehandlung, die in einer plastischen Deformation und einem Reflow der verformbaren Schicht (2) resultiert; und
Transferieren der zumindest teilweise relaxierten Inseln (3) des verspannten Materials auf ein Zielsubstrat (5).

2. Verfahren gemäß Anspruch 1, in dem der Schritt des Transferierens der zumindest teilweise relaxierten Inseln (3) des verspannten Materials auf das Zielsubstrat (5) ein Abscheiden einer weiteren verformbaren Schicht (4), die eine Schicht niedriger Viskosität ist, auf die zumindest teilweise relaxierten Inseln (3) des verspannten Materials und Bondieren der weiteren verformbaren Schicht (4) auf das Zielsubstrat (5) umfasst; und weiterhin mit dem Schritt des Relaxierens der zumindest teilweise relaxierten Inseln (3) des verspannten Materials, die auf das Zielsubstrat (5) transferiert sind, durch eine zweite Wärmebehandlung.

3. Verfahren gemäß einem der Ansprüche 1 bis 2, das weiterhin umfasst
Aufwachsen der Schicht des verspannten Materials auf einem Saatsubstrat;
Implantieren von Ionen in dem Saatsubstrat unterhalb des verspannten Materials, um eine geschwächte Schicht zu bilden; und
Ablösen des verspannten Materials von dem Saatsubstrat an der geschwächten Schicht durch eine weitere Wärmebehandlung.

4. Verfahren gemäß einem der vorhergehenden Ansprüche, in dem das Saatsubstrat und das Zwischensubstrat und/oder das Zwischensubstrat und das Zielsubstrat aus demselben Material sind, das insbesondere Saphir, Silizium, SiC oder Ge umfasst.

5. Verfahren gemäß einem der vorhergehenden Ansprüche, in dem die verformbare Schicht (2) eine Absorptionsschicht umfasst, die geeignet ist, elektromagnetische Strahlung zu absorbieren.

6. Verfahren gemäß einem der vorhergehenden Ansprüche, in dem die Schicht des verspannten Materials InGaN umfasst oder daraus besteht und/oder die verformbare Schicht (2) ein Borphosphorsilikatglass, BPSG, oder eine SiO₂-Zusammensetzung mit Bor oder Phosphor umfasst oder daraus besteht.

7. Verfahren zur Herstellung eines Halbleiterbauteils, das Bereitstellen eines zumindest teilweise relaxierten verspannten Materials (3) auf einem Zielsubstrat (5) gemäß einem der vorhergehenden Ansprüche umfasst, und weiterhin ein epitaktisches Aufwachsen von zumindest einer Materialschicht, insbesondere von Schichten für LED oder photovoltaische oder Laser-Schichten, auf dem ausgebildeten zumindest teilweise relaxierten verspannten Material umfassend.

## Revendications

1. Procédé de formation d'îlots de matériau contraint au moins partiellement détendus sur un substrat cible, comprenant les étapes effectuées à la suite consistant à
transférer une couche de matériau contraint depuis un substrat de germe jusqu'à un substrat intermédiaire (1), comprenant le dépôt d'une couche compatible (2) qui est une couche de faible viscosité sur la couche de matériau contraint et la liaison de la couche compatible (2) au substrat intermédiaire (1) ;
former des îlots de matériau contraint (3) à partir de la couche de matériau contraint en mettant en forme la couche de matériau contraint de sorte que les îlots de matériau contraint sont séparés par des espaces qui s'étendent jusqu'au substrat intermédiaire (1) de sorte qu'il ne reste pratiquement aucun matériau de la couche compatible (2) au fond des espaces ;
détendre au moins partiellement les îlots de matériau contraint (3) par un premier traitement thermique ayant pour résultat une déformation plastique et une refusion de la couche compatible (2) ; et
transférer les îlots de matériau contraint au moins partiellement détendus (3) sur un substrat cible (5).

2. Procédé selon la revendication 1, dans lequel l'étape de transfert des îlots de matériau contraint au moins partiellement détendus (3) sur le substrat cible (5) comprend le dépôt d'une autre couche compatible (4) qui est une couche de faible viscosité sur les îlots de matériau contraint partiellement détendus (3) et la liaison de l'autre couche compatible (4) au substrat cible (5) ; et comprenant en outre l'étape consistant à détendre les îlots de matériau contraint au moins partiellement détendus (3) transférés sur le substrat cible (5) par un second traitement thermique.

3. Procédé selon l'une des revendications 1 à 2, comprenant en outre les étapes consistant à
faire croître la couche de matière contraint sur un substrat de germe ;
implanter des ions dans le substrat de germe en dessous du matériau contraint pour former une couche affaiblie ; et
détacher le matériau contraint du substrat de germe au niveau de la couche affaiblie par un autre traitement thermique.

4. Procédé selon l'une des revendications précédentes, dans lequel le substrat de germe et le substrat intermédiaire et/ou le substrat intermédiaire et le substrat cible sont constitués du même matériau, en particulier, comprenant du saphir, du silicium, SiC, ou Ge.

5. Procédé selon l'une des revendications précédentes, dans lequel la couche compatible (2) comprend une couche d'absorption appropriée pour absorber un rayonnement électromagnétique.

6. Procédé selon l'une des revendications précédentes, dans lequel la couche de matériau contraint comprend ou est constituée d'InGaN et/ou la couche compatible (2) comprend ou est constituée de verre de borophosphosilicate, BPSG, ou d'un composé de SiO₂⁻ comprenant du bore ou du phosphore.

7. Procédé de fabrication d'un dispositif à semi-conducteur, consistant à fournir un matériau contraint au moins partiellement détendu (3) sur un substrat cible (5) selon l'une des revendications précédentes, et comprenant en outre une croissance épitaxiale d'au moins une couche de matériau sur le matériau contraint au moins partiellement détendu formé, en particulier, des couches pour des couches de dispositif LED ou photovoltaïque ou laser.
